# EUROPÄISCHE PATENTANMELDUNG

(11) **EP 2 317 333 A1**
(43) Veröffentlichungstag der Anmeldung: **04.05.2011**
(21) Anmeldenummer: 09013685.4
(22) Anmeldetag: 30.10.2009
(51) Int. Cl.: G01R 33/54, G01R 33/561

(54) **MRT-Betriebsverfahren**

(71) Anmelder: Max-Delbrück-Centrum für Molekulare Medizin (MDC), 13092 Berlin (DE)
(72) Erfinder: Niendorf, Thoralf, 52074 Aachen (DE); Hezel, Fabian, 10437 Berlin (DE)
(74) Vertreter: COHAUSZ DAWIDOWICZ HANNIG & SOZIEN

(57) **Zusammenfassung**

Die Erfindung betrifft ein Verfahren zum Betrieb eines Magnetresonanztomographen zur ortsaufgelösten Spinresonanzmessung an einem Objekt, welches in einem statischen Magnetfeld B0 angeordnet wird, wodurch sich eine Ausrichtung der Spins des Objektes und eine longitudinale Nettomagnetisierung Mz entlang der Magnetfeldrichtung Z ergibt, wobei mittels wenigstens eines Hochfrequenz-Anregungs-Impulses in Resonanz ein Spin-Flip um einen gewünschten Flip-Winkel erzeugt wird, bei dem eine transversale Magnetisierungskomponente Mxy erzeugt oder geändert wird, deren T2*-Relaxation zur Durchführung suszeptibilitätsgewichteter Messungen erfasst wird wofür eine messtechnische Erfassung von mehreren Spin-Echo-Signalen aus einem gewünschten Volumenelement des Objektes erfolgt, die nach einem HF-Anregungsimpuls durch eine Sequenz von untereinander äquidistanten Hochfrequenz-Refokussierungsimpulsen erzeugt werden, wobei den Echo-Signalen vor deren Erfassung eine Suszeptibilitätsabhängigkeit aufgeprägt wird durch eine zwischen dem Hochfrequenz-Anregungsimpuls und dem ersten Hochfrequenz-Refokussierungsimpuls zusätzlich eingefügte Evolutionszeit zur Entwicklung der durch Inhomogenitäten des Magnetfeldes erzeugten Dephasierung der durch den HF-Anregungsimpuls erzeugten transversalen Magnetisierung Mxy und wobei der Ort des messtechnisch erfassten Volumenelements des Objektes durch mehrere zumindest zeitweise dem homogenen Magnetfeld B0 überlagerte Gradientenmagnetfelder bestimmt wird und der Start und/oder Vorbereitungssequenzen einer Messung an eine oder mehrere erfasste Formen physiologischer Bewegung synchronisiert wird/werden, wobei innerhalb der Zeit eines R-R-Intervalls des Herzens eine Vorbereitungssequenz zur Unterdrückung von Signalbeiträgen aus dem Blut ausgeführt wird, insbesondere durch eine Sättigungssequenz und wobei zumindest der erste Refokussierungsimpuls (3) zeitgleich mit einem schichtselektiven Gradientenmagnetfeld (4) erzeugt wird, welches orthogonal wirkt zur dem schichtselektiven Gradientenmagnetfeld (2) zur Zeit der Erzeugung des HF-Anregungsimpulses (1) und wobei die Messwerterfassung und Bilderzeugung mittels einer Unterabtastung des Datenraumes und/oder einer partiellen Abtastung des Datenraumes erfolgt.

## Beschreibung

Die Erfindung betrifft ein Verfahren zum Betrieb eines Magnetresonanztomographen zur ortsaufgelösten Spinresonanzmessung an einem Objekt, insbesondere einem lebenden Objekt, welches in einem statischen Magnetfeld B0 angeordnet wird, wodurch sich eine Ausrichtung der Spins des Objektes und eine longitudinale Nettomagnetisierung Mz entlang der Magnetfeldrichtung Z ergibt, wobei mittels wenigstens eines Hochfrequenz-Anregungs-Impulses in Resonanz ein Spin-Flip um einen gewünschten Flip-Winkel erzeugt wird, bei dem eine transversale Magnetisierungskomponente Mxy erzeugt oder geändert wird, deren T2*-Relaxation zur Durchführung suszeptibilitätsgewichteter Messungen erfasst wird wofür eine messtechnische Erfassung von mehreren Spin-Echo-Signalen aus einem gewünschten Volumenelement des Objektes erfolgt, die nach einem HF-Anregungsimpuls durch eine Sequenz von untereinander äquidistanten Hochfrequenz-Refokussierungsimpulsen erzeugt werden, wobei den Echo-Signalen vor deren Erfassung eine Suszeptibilitätsabhängigkeit aufgeprägt wird durch eine zwischen dem Hochfrequenz-Anregungsimpuls und dem ersten Hochfrequenz-Refokussierungsimpuls zusätzlich eingefügte Evolutionszeit zur Entwicklung der durch Inhomogenitäten des Magnetfeldes erzeugten Dephasierung der durch den HF-Anregungsimpuls erzeugten transversalen Magnetisierung Mxy und wobei der Ort des messtechnisch erfassten Volumenelements des Objektes durch mehrere zumindest zeitweise dem homogenen Magnetfeld B0 überlagerte Gradientenmagnetfelder bestimmt wird und der Start und/oder Vorbereitungssequenzen einer Messung an eine oder mehrere erfasste Formen physiologischer Bewegung synchronisiert wird/werden.

Magnetresonanztomographen sind im Stand der Technik allgemein bekannt und umfassen im Wesentlichen Spulen bzw. Gradientenspulen zur Erzeugung mehrerer, insbesondere orthogonaler Magnetfelder, insbesondere in einem kartesischen Koordinatensystem, wobei üblicherweise eine Spule oder Spulenanordnung vorgesehen ist, um ein starkes statisches Magnetfeld 80 entlang einer Z-Richtung des gewählten Koordinatensystems zu erzeugen, beispielsweise mit Feldstärken von mehreren Tesla. Hierfür werden üblicherweise supraleitende Spulenanordnungen eingesetzt.

Senkrecht sowie auch parallel zu der so erzeugten Magnetfeldrichtung B0 werden darüber hinaus weitere Spulen bzw. Spulenanordnungen vorgesehen, um zum statischen Magnetfeld senkrechte sowie auch zumindest ein dazu paralleles Magnetfeld zu erzeugen, wobei diese Magnetfelder insbesondere als Gradientenmagnetfelder ausgebildet werden, d.h. also Magnetfelder, deren Magnetfeldstärke sich entlang einer Koordinatenachse ändert. Durch die Überlagerung wird so erreicht, dass sich die Resonanzfrequenz bzw, Präzessionsfrequenz der Spins abhängig von dem ortsvariablen Gesamtmagnetfeld ändert, wodurch ortsaufgelöste Messungen realisiert werden können.

Das Messprinzip, um mit einem solchen Magnetresonanztomographen Schnittbilder durch lebende Objekte erzielen zu können, beruht darauf, dass sich die Spins, insbesondere Wasserstoffspins, des lebenden Objektes innerhalb des statischen Magnetfeldes B0 ausrichten und um die Magnetfeldrichtung, somit also um die Z-Achse präzedieren.

Durch einen Hochfrequenzanregungspuls, der auf die sogenannte Lamorfrequenz der präzedierenden Spins abgestimmt ist und üblicherweise zumindest in der Amplitude und der Hüllkurve grundsätzlich programmierbar ist, kann eine Auslenkung der Spins aus ihrem Gleichgewicht erfolgen, so dass die in dem homogenen Magnetfeld B0 erzeugte Nettomagnetisierung Mz um den sogenannten Flipwinkel ausgelenkt wird, so dass eine transversale Magnetisierungskomponente Mxy innerhalb der XY-Ebene des gewählten Koordinatensystems vorliegt. Hierbei ist der Flipwinkel im Wesentlichen von dem HF-Anregungsimpuls abhängig und somit auch anwendungspezifisch programmierbar.

Die so erzeugte transversale Magnetisierungskomponente Mxy ist zeitlich nicht stabil und relaxiert aufgrund verschiedener Prozesse mit verschiedenen Relaxationszeiten, wobei sich die unterschiedlichen Prozesse überlagern.

Dem einschlägigen Fachmann sind diese Prozesse bekannt und werden als T1-, T2- sowie T2*-Relaxationen bezeichnet. Hierbei entspricht die T1-Reiaxation der zeitlichen Zunahme der Mz-Magnetisierungskomponente, wenn die Magnetisierungskomponente Mxy wieder in die Richtung der Z-Achse zurückkippt, wohingegen die T2-Relaxation auf einer Dephasierung der einzelnen Spins innerhalb der XY-Ebene beruht und zu einer Abschwächung des Signals führt, welches auf der Abstrahlung einer elektromagnetischen Welle beruht aufgrund der Rotation der transversalen Magnetisierungskomponente in der XY-Ebene.

Weiterhin ist dem T2-Signalabfall eine Dephasierung überlagert, die durch makroskopische und mikroskopische Magnetfeldinhomogenitäten in dem untersuchten Gewebe oder dem untersuchten Objekt gegeben sind, die also auf Unterschieden in der magnetischen Suszeptibilität des Gewebes beruhen. Die effektive Relaxationsrate, die sowohl T2-Relaxation als auch Suszeptibilitätseffekte beinhaltet, wird als T2* Relaxation bezeichnet. Die T2* Relaxation ist demnach schneller als die T2-Relaxation.

Neben der Programmierung von zumindest zeitweise wirkenden Gradientenmagnetfeldern zur Erzielung einer Ortsauflösung in dem untersuchten Objekt bei der Messvorbereitung und/oder Signalauslesung, was dem Fachmann grundsätzlich hinlänglich bekannt ist, gibt es verschiedene Möglichkeiten, sogenannte Vorbereitungs- und Messsequenzen von Pulsen zur Ansteuerung der jeweiligen Spulen ((Gradienten-)Magnetfeldspulen und/oder Hochfrequenz-Spulen) zu programmieren, um selektiv die T1-, T2- oder T2*-Relaxationszeiten messtechnisch erfassbar zu machen. In diesem Zusammenhang wird auch von einer entsprechenden Wichtung bezüglich T1, T2 oder T2* bei der Messwerterfassung gesprochen.

Die Erfassung erfolgt durch Sammlung der Daten im sogenannten Datenraum oder auch k-Raum bei der innerhalb einer Sequenz fortwährenden Schaltung des sogenannten Phasencodier-Gradienten vor und der Schaltung eines sogenannten Frequenzcodiergradienten während der Datenaufnahme, um in Verbindung mit dem sogenannten Schichtgradienten zum Zeitpunkt des HF-Anregungsimpulses insgesamt eine 3D-Ortsauflösung zu erzielen. Die im Datenraum aufgenommenen Daten werden dann durch eine Fouriertransformation in eine Bilddarstellung umgewandelt.

Suszeptibilitätsgewichtete Messungen sind dabei von besonderem Vorteil, da diese auf Magnetfeldinhomogenitäten innerhalb des untersuchten Gewebes beruhen und somit sehr sensitiv sind für die verschiedenen möglichen Gewebearten. Diesbezügliche Messungen hingegen sind sehr fehleranfällig, so dass derartige Messungen oftmals durch messtechnische Artefakte überlagert sind, die eine Auswertung der Bilder erschweren.

Zu den zentralen Herausforderungen der Magnetresonanz (MR)-Bildgebung des kardiovaskulären Systems gehören eine unbeeinträchtigte Reproduzierbarkeit, eine räumliche Auflösung im Millimeterbereich und insbesondere die zwingende Notwendigkeit zur detailgetreuen geometrischen Abbildung der Anatomie. Zusätzlich erfordert eine suszeptibilitätsgewichtete MR-Darstellung des kardiovaskulären Systems Bildgebungstechniken, die mit entsprechender Wirkung sehr geringe suszeptibilitätsbedingte Signalunterschiede zwischen normalen und anormalen Gewebetypen zuverlässig diagnostisch auswertbar aufnehmen, darstellen bzw. quantifizieren können.

Ein Verfahren zum Betrieb eines Magnetresonanztomographen ist z.B. durch die Veröffentlichung DE 10 2007 045 172 B3 bekannt geworden, bei dem eine eigentlich Suszeptibilitätseffekte unterdrückende Spin-Echo-Technik mit ihren sonstigen Vorteilen nutzbar gemacht werden konnte, um Suszeptibilitätseffekte zu messen durch Einführung einer zusätzlichen Evolutionszeit zwischen HF-Anregungsimpuls und erstem Refokussierungsimpuls um so den Suzeptibilitätseffekten eine Möglichkeit zur zeitlichen Entwicklung zu geben, so dass diese durch die Rephasierung nicht mehr aufgehoben werden.

Dabei weist diese bekannt gewordene Technik, insbesondere auch durch die dort verwendeten Maßnahmen zur Unterdrückung von Signalbeiträgen aus dem Blut, den Nachteil auf, dass lange Messzeiten zu akzeptieren sind, wobei beispielsweise eine Vorbereitungssequenz zur Blutunterdrückung in einem vorgelagerten RR-Intervall des Herzschlages liegt und die eigentliche Messphase in einem nachfolgenden RR-Intervall liegt. Wegen der Möglichkeit zwischenzeitlich stattfindender Bewegungen wurde zur Bewegungskompensation eine weitere die Messzeit verlängernde Technik verwendet, um Organbewegungen zu erfassen und davon abhängig die Messdatenakquisition zu steuern. So erwies sich diese bekannte Technik zwar als sehr genau, jedoch für den klinischen Einsatz als zu langsam.

Aufgabe der Erfindung ist es, ein Verfahren zum Betrieb eines Magnetresonanztomographen bereitzustellen, welches die Erfassung suszeptibilitätsgewichteter Messungen ermöglicht, ohne die damit einhergehenden Nachteile bekannter Bildgebungstechniken aufzuweisen, insbesondere die damit verbundenen langen Messzeiten. Es ist weiterhin die Aufgabe, mit einem solchen Verfahren und den programmierten Sequenzen zur Ansteuerung von HF-Impulsen und den Spulenanordnungen eine Bildgebung zu erzielen, die es ermöglicht, Artefakte durch Blutfluss zu unterdrücken.

So soll es weiterhin mit dem erfindungsgemäßen Verfahren bevorzugt möglich sein, eine Bildgebungstechnik zu realisieren, die hoch aufgelöste 2D- oder 3D-Darstellungen, insbesondere des Herzens und des kardiovaskulären Systems mit hoher und diagnostisch verwertbarer Bildqualität umsetzt und damit eine breite Anwendungspalette erschließt. Insbesondere sollen hierzu Anwendungen gehören, wie beispielsweise die Untersuchung der Endothel-Funktion von Gefäßen, die Erkennung stressinduzierter Angina Pectoris, die Abbildung und Quantifizierung des Eisengehaltes von Myokardgewebe sowie die Abbildung der myokardialen Sauerstoffsättigung des Blutes, die Differenzierung zwischen Arterien und Venen und die Detektion myokardialer Perfusionsdefizite.

Erfindungsgemäß wird diese Aufgabe dadurch gelöst, dass innerhalb der Zeit eines R-R-Intervalls des Herzens eine Vorbereitungssequenz zur Unterdrückung von Signalbeiträgen aus dem Blut ausgeführt wird, insbesondere durch eine Sättigungssequenz, wobei weiterhin zumindest der erste Refokussierungssimpuls zeitgleich mit einem schichtselektiven Gradientenmagnetfeld erzeugt wird, welches orthogonal wirkt zur dem schichtselektiven Gradientenmagnetfeld zur Zeit der Erzeugung des HF-Anregungsimpulses, und wobei die Messwerterfassung und Bilderzeugung mittels einer Unterabtastung des Datenraumes und/oder einer partiellen Abtastung des Datenraumes erfolgt, insbesondere in Verbindung mit einer Fouriertransformation, bevorzugt einer Half-Fourier-Bildgebung.

Statt wie bisher im Stand der Technik durch globale Inversion der Nettomagnetisierung und anschließender schichtselektiver Wiederherstellung eine Unterdrückung von Signalbeiträgen aus dem Blut zu erhalten, wird nun erfindungsgemäß zur Vorbereitung der messtechnischen Erfassung ein Verfahren zur Unterdrückung von Signalbeiträgen aus dem Blut angewendet, welches innerhalb ein und desselben RR-Intervalls eines Herzens durchgeführt werden kann zusammen mit der weiteren Messsequenz.

Beispielsweise kann hierfür die Technik der Blutsättigung, die sogenannte Sättigungsschicht durchgeführt werden. Bei einer Herz-MRT kann diese Form der Blutsättigung insbesondere unter Einbeziehung der Pulmonargefäße und/oder der Vorhöfe erfolgen. Hierbei wird, insbesondere schichtselektiv, d.h. in Verbindung mit einem gleichzeitigen Gradientenmagnetfeld eine Folge von HF-Impulsen erzeugt, mittels denen im Mittel Signalbeiträge inklusive Blut in der Sättigungsschicht gesättigt und dephasiert werden und somit das aus dem Bereich der Sättigungsschicht in die abzubildenden Schicht, z.B. Herzkammern, fließende Blut keine Nettomagnetisierung in Z-Richtung (Mz=0) oder transversale Magnetisierung in XY-Richtung (Mxy=0) aufweist und deshalb nach erneuter Anregung in der abzubildenden Schicht, z.B. innerhalb der Herzkammem, keine Signalbeiträge liefert.

Durch schichtselektive Gradientenmagnetfelder kann eine solche Sättigung in einer Schicht unmittelbar vor und/oder hinter der eigentlich aufzunehmenden Schicht erzeugt werden, so dass nur gesättigtes Blut aus dieser Richtung in die aufzunehmende Schicht gelangt und dort keinen Signalbeitrag hervorruft. Eine solche Sättigung bzw. Sättigungsschicht kann bei der MRT Bildgebung kontinuierlich erzeugt werden und durch die Gradientenmagnetfelder so gesteuert werden, dass diese Sättigungsschicht mit der aufzunehmenden Schicht mitwandert.

Diese Art der Blutsättigung hat darüber hinaus den Vorteil, dass sie auch in Verbindung mit Kontrastmitteln angewendet werden kann, da auch diese Mittel gesättigt werden.

Da mit dem Ansatz der Sättigung keine zusätzliche Wartezeit zwischen der vorbereitenden Blutunterdrückung und dem Zeitpunkt der Bildgebung erfordert wird, kann diese Art der Blutunterdrückung innerhalb desselben Herzzyklus (RR-Intervals des Herzens) erfolgen, ebenso wie die weitere Messung. Gegenüber der aus der DE 10 2007 045 172 B3 bekannten Technik wird so bereits ein Geschwindigkeitsvorteil in der Größe eines Faktors 2 erzielt.

Die Spin-Echo-Technik, bei welcher mit einem schichtselektiv wirkenden Refokussierungs-HF-Impuls (z.B. 180°) eine Phasenumkehr der Spins erzeugt wird, wird hier weiterhin derart angewendet, dass nicht wie üblich der schichtselektive Refokussierungsimpuls in derselben Schicht angewendet wird wie der initiale Anregungsimpuls zur Erzeugung des Spinflip, sondern in einer dazu orthogonalen Ebene, z.B. in Phasenkodierrichtung durch gleichzeitiges Erzeugen des Phasenkodier-Gradientenmagnetfeldes zusammen mit dem Refokussierungsimpuls.

Die Rephasierung und das nachfolgende Spinecho erfolgt demnach nur aus den Objektbereichen in dem Überlagerungsbereich der mit der Anregung ausgewählten Schicht und der mit der Rephasierung dazu senkrechten ausgewählten Schicht. Es resultiert hieraus eine volumenselektive Anregung die den effektiv angeregten und betrachteten Bildausschnitt verkleinert und deshalb Einfaltungen vermeidet.

Entlang der beispielhaften Phasenkodierrichtung, d.h. der Richtung des phasenkodierenden Gradientenmagnetfeldes erfolgt demnach in diesem Beispiel eine Reduktion des Volumens des Objektes, aus dem Signalbeiträge kommen, so dass diese fehlenden Signalbeiträge auch nicht phasenselektiv sortiert werden müssen.

Die Anzahl der Phasenkodierschritte, d.h. die Anzahl der aufeinanderfolgenden Einschaltungen des Phasenkodier-Gradientenmagnetfeldes mit verschiedenen Magnetfeldstärken kann entsprechend reduziert werden. Auch durch diese Maßnahme lässt sich die Messzeit gegenüber dem genannten Stand der Technik reduzieren, z.B. auf 50%.

Grundsätzlich kann die Rephasierung auch in Frequenzkodierrichtung erfolgen durch gleichzeitiges Erzeugen des Frequenzkodier-Gradientenmagnetfeldes zusammen mit dem Refokussierungsimpuls.

Ansonsten ist es erfindungsgemäß weiterhin vorgesehen, dass die messtechnische Erfassung von mehreren Spin-Echo-Signalen aus einem gewünschten Volumenelement (Voxel) des Objektes erfolgt, die nach einem HF-Anregungsimpuls durch eine Sequenz von untereinander äquidistanten Hochfrequenz-Refokussierungsimpulsen erzeugt werden.

Die Erfassung von mehreren Spin-Echo-Signalen an sich ist dem Fachmann hinlänglich bekannt und beruht darauf, dass nach einem HF-Anregungsimpuls zur Erzeugung eines Spin-Flip um einen gewünschten Flip-Winkel in Folge mehrere äquidistante Hochfrequenz-Refokussierungsimpulse in das Objekt eingestrahlt werden, um eine Dephasierung der transversalen Mxy-Magnetisierungskomponenten umzukehren, also eine Rephasierung zu erzeugen. Bei vollständiger Rephasierung ergibt sich ein Echo-Signal, dass frequenzselektiv durch ein gleichzeitig geschaltetes Frequenzkodier-Gradientenmagnetfeld mit der zuvor festgelegten Phasenkodierung erfasst werden kann.

Eine darüber hinausgehende Beschleunigung um wenigstens einen weiteren Faktor 2 erfährt das Verfahren gemäß der Erfindung durch die Messwerterfassung und Bilderzeugung mittels einer Unterabtastung des Datenraumes und/oder der teilweisen Abtastung des Datenraumes, insbesondere mittels einer Fouriertransformation, bevorzugt einer Partial- oder Half-Fourier-Rekonstruktion.

Im Falle der Unterabtastung macht sich die Erfindung die Erkenntnis zunutze, dass nicht alle Inkremente/Phasen im Phasenkodier-Gradientenmagnetfeld nicht notwendigerweise physikalisch geschaltet werden müssen, um Daten des Datenraumes aufzunehmen, sondern beispielsweise nur jede zweite oder dritte oder sonstige (N-te) Phasengröße, die z.B. ganzzahlig aber auch rational sein kann, geschaltet wird. Hierdurch ergibt sich eine N-fache Unterabtastung des Datenraumes und somit eine N-fache Reduzierung der Datenmenge.

Half-Fourier nutzt die Symmetrie des Datenraums. Dabei wird die eine Hälfte des Datenraums ausgelassen. Die Rekonstruktion ist bei der Half-Fourier Rekonstruktion auf reele Zahlen beschränkt, auf die man sich bei der Bildgebung in der Regel beschränken kann. k-t Verfahren tasten den Datenraum in der Form ab, dass Sie eine oder mehrere Datenraum-Zeilen auslassen.

Die bei der Unterabtastung verursachten Einfaltungen auf Grund der Verletzung des Nyquist Theorems können durch geeignete Rekonstruktionstechniken kompensiert werden, ebenso wie die ausgelassenen Daten durch geeignete Rekonstruktionstechniken vervollständigt werden können. Z.B. können aufgrund bekannter räumlicher und zeitlicher Korrelationen in Zeitserien von Bilddaten die "fehlenden" Informationen hinzugerechnet werden, z.B. mittels den Methoden des sogenannten "k-t-BLAST" oder "k-t-PCA".

Rekonstruktionstechniken wie k-t BLAST und k-t PCA nutzen dabei Vorwissen aus, um diese Einfaltungen zu vermeiden. Bei k-t BLAST besteht das Vorwissen in der Form, dass man davon ausgeht dass die Daten ein periodisches, wiederkehrendes Verhalten aufweisen.

Hier hat sich überraschend gezeigt, dass diese Methoden auch für MRT-Messungen zum Einsatz kommen können, bei denen in Zeitserien nicht mehr nur in ausgewählten Bildbereichen Signalintensitätsänderungen auftreten, sondern wie hier im gesamten Bild, so dass keinerlei statische Signalanteile oder Bildanteile vorliegen. Es kann sich so auf Grund der Unterabtastung ein Geschwindigkeitsvorteil von bis zu einem Faktor 8 und größer ergeben.

Ein weiterer Geschwindigkeitsvorteil ergibt sich durch die Haff-Fourier-Technik, die in Verbindung mit den Komponenten der Unterabtastung mit der volumenselektiven Anregung und der Blutsättigung eingesetzt wird.

Hier macht sich die Erfindung die Erkenntnis zunutze, dass aufgrund von Symmetrien des Datenraumes nicht alle an sich notwendigen Phasen im Phasenkodier-Gradientenmagnetfeld geschaltet werden müssen, um die Daten des Datenraumes aufzunehmen, sondern nur Teile des Datenraumes aufgenommen werden und fehlende Datenraumanteile durch Extrapolation oder durch Bildung komplex konjugierter Werte existierender Daten vervollständigt werden. Der Geschwindigkeitsvorteil des Ansatzes der Aufnahme partieller Anteile des Datenraumes mittels der Half-Fourier-Technik kann im Bereich von 40% liegen.

Die Kombination dieser Techniken reduziert die gesamte Meßzeit auf weniger als 10-20 Sekunden, so dass die Möglichkeit besteht, auf die im Stand der Technik der DE 10 2007 045 172 bekannte Kompensationstechnik betreffend Atembewegungen vollständig zu verzichten, so dass deren geringe Datenerfassungseffizienz vermieden wird. Eine vollständige Datenaufnahme kann somit erfindungsgemäß innerhalb einer Atemanhalteperiode von ca. 10 bis 20 Sekunden erfolgen.

In einer vorteilhaften Weiterbildung kann es auch vorgesehen sein, dass die schichtselektiven Gradientenmagnetfelder, die zeitgleich zu den Refokussierungsimpulsen erzeugt werden, bei wenigstens zwei aufeinanderfolgenden Refokussierungsimpulsen orthogonal zueinander angeordnet sind.

So kann der erste Refokussierungssimpuls in einer Schicht orthogonal zu der Schicht angewendet werden, die bei der Anregung ausgewählt wurde und bei einem zweiten Refokussierunsimpuls orthogonal zu beiden vorher ausgewählten Schichten. Mit der fortlaufenden Erzeugung von Refokussierungsimpulsen können die ebenso fortlaufend ausgewählten Schichten jeweils orthogonal gewählt werden. Beginnend mit der Anregung können die Gradientenmagnetfelder zur Wahl der Schichten z.B. in der Reihenfolge Schichtgradient, Phasenkodiergradient; Frequenzkodiergradient geschaltet werden, ggfs periodisch wiederholend.

Hierdurch kann der angeregte Bereich in der dritten Dimension reduziert werden. Damit verbunden ist bei Beibehaltung der räumlichen Auflösung eine weitere Reduzierung des Datenvolumens, sowie eine mögliche Verkürzung zwischen den Abständen der Refokussieungsimpulsen, die mit einer weiteren Reduzierung der Bildaufnahmezeit einhergeht.

Es besteht in einer weiteren Ausbildung des Verfahrens auch die Möglichkeit eine Diffusionswichtung vorzunehmen durch Erzeugung eines bipolaren zeitlich beschränkt wirkenden Gradientenmagnetfeldes vor einem Refokussierungssimpuls oder zweier unipolarer Gradientenmagnetfelder gleicher Dauer um einen Refokussierungsimpuls herum. Bevorzugt kann die Erzeugung des bipolaren Gradienten innerhalb der sich nach dem HF-Anregungsimpuls anschließenden Evolutionszeit erfolgen, wodurch diese Zeit nicht ungenutzt innerhalb einer Messsequenz verstreicht.

Jedes der geschalteten Gradientenmagnetfelder, d.h. die beiden verschiedener Polarität und gleicher Dauer unmittelbar nacheinander oder gleicher Polarität und Dauer um einen Refokussierungsimpuls herum bewirken im ersten geschalteten Gradientenmagnetfeld eine gezielte Dephasierung und im zweiten eine Umkehrung der vorherigen Dephasierung, also eine Rephasierung. Durch Diffusionseffekte bedingte Bewegung oder durch stochastische Bewegung, z.B. von Blut, kann nach dem Schalten der Paare bipolarer oder unipolarer Gradienten eine effektive Netto-Dephasierung übrig bleiben, die in Folge in einer Signalabnahme resultiert. Es können so auch Signalanteile, die durch die einleitende Blutunterdrückung nicht vollständig eliminiert wurden, berücksichtig

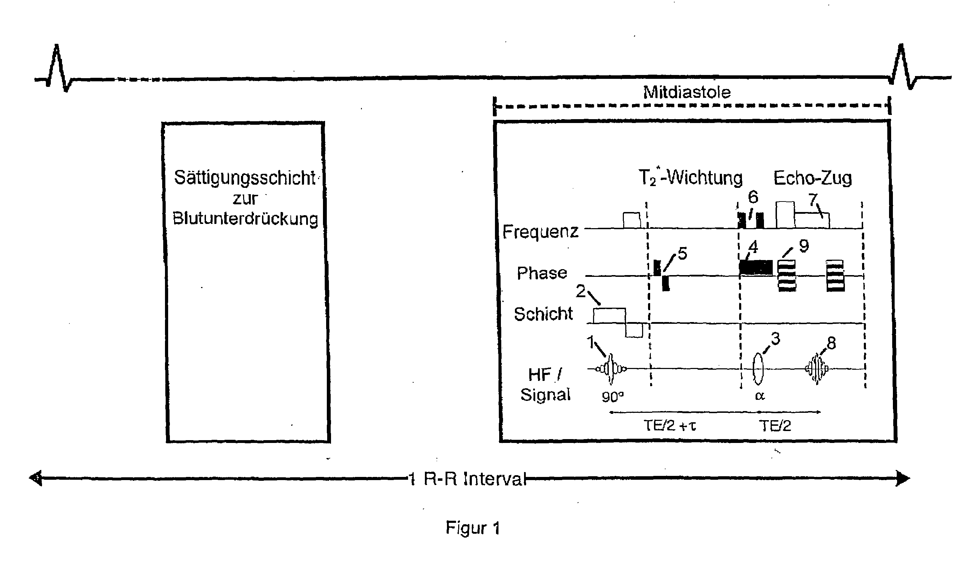

Ein Ausführungsbeispiel der Erfindung ist in der Figur 1 dargestellt. Diese zeigt die Aneinanderreihung von Vorbereitungs- und Messsequenz sowohl zur Unterdrückung von Blutartefakten, sowie auch zur Aufnahme von Spin-Echo-Messsignalen.

Die Gesamtsequenz ist hier innerhalb eines RR-Intervalls des Herzens angeordnet. Zeitlich vorgelagert ist nach der Herztriggerung der GesamtSequenz eine hier nur symbolisch dargestellte Vorbereitungsequenz, um Blutartefakte zu vermeiden, nämlich hier insbesondere durch gezielte Ansteuerung und Auslösung von HF-Pulsen, insbesondere schichtselektiver Art, um eine verschwindende Magnetisierung in Z-Richtung oder in transversaler Ebene im Blut zu erzielen, wie es beispielsweise eingangs erläutert wurde..

Im rechtsseitigen mit Mitdiastole überschriebenen Teil ist beispielhaft eine Messsequenz dargestellt, die für verschiedene Phasenkodierungen wiederholt auszuführen ist nach einer Anregung, erkennbar an der horizontal gestreift dargestellten Wiedergabe der Phasenkodier-Gradientenmagnetfelder 9. Jede der Angaben "Schicht", "Phase" und "Frequenz" bedeutet ein schaltbares Gradientenmagnetfeld, die alle orthogonal zueinander angeordnet sind.

Erkennbar ist hierbei jeweils die Ansteuerung innerhalb einer Hochfrequenzspule zur Erzeugung eines HF-Anregungsimpulses 1, ebenso wie die Ansteuerung von Gradientenspulen zur Erzeugung von Gradientenmagnetfeldern, um eine Ortsselektivität und/oder bestimmte gewünschte Wichtungen bei der Untersuchung eines Objektes zu erzielen. Grundsätzlich kann die Spule zur Erzeugung der HF-Impulse auch zur Erfassung der Mess-Signale, also der Echos genutzt werden, oder alternativ eine separate Empfangsspule. Der Anregungsimpuls 1 ist hier beispielhaft als ein 90°-Puls symbolisiert, der also die Nettomagnetisierung aus der Z-Richtung um 90 Grad in die transversale Ebene dreht. Gleichzeitig zum Anregungsimpuls 1 wirkt ein schichtselektives Gradientenmagnetfeld 2, um die Schicht im Objekt auszuwählen, die durch den Impuls 1 zum Spinflip angeregt werden soll. Das Gradientenmagnetfeld 2 ist hier bipolar mit invertierter aber nur halb so lang dauernder Polarität dargestellt, um eine gleichzeitig erzeugte Dephasierung zu kompensieren.

Die Figur 1 zeigt weiterhin, dass nach dem Hochfrequenzanregungspuls 1 eine Evalutionszeit Tau abgewartet wird, nach der ein erster Refokussierungsimpuls 3 in das, insbesondere lebende, Objekt eingestrahlt wird, um die Dephasierung der Mxy-Magnetisierungs-Komponente durch sodann periodische Abfolge weiterer Refokussierungsimpulse immer wieder umzukehren und so die sogenannten Spin-Echo-Signale zu generieren.

Hierbei bewirkt der Einschub der zusätzlichen Evolutionszeit Tau, die eine Gesamtzeit zwischen Puls 1 und erstem Refokussierungssimpuls 3 erzeugt, die über den halben äquidistanten zeitlichen Abstand zwischen den einzelnen Refokussierungsimpulsen 3 hinausgeht, dass sich vor dem ersten Refokussierungimpuls 3 eine Dephasierung der transversalen Magnetisierungskomponente Mxy aufbauen kann, die ausschließlich durch Inhomogenitäten des gesamten Magnetfeldes am Ort der Untersuchung hervorgerufen ist. Dieser Dephasierungsanteil bleibt demnach bei den einzelnen folgenden erzeugten Spin-Echo-Signalen erhalten und kann durch die Auswertung der Spin-Echo-Signale ermittelt werden, so dass hier selbst mit der ansonsten prinzipbedingt für Suszeptibilitätsunterschiede insensitiven Spin-Echo-Technik suszeptibilitätsgewichtete Bildgebung möglich wird. Es kann demnach eine Folge von Messwerten für verschiedene gewählte Evolutionszeiten Tau aufgenommen und ausgewertet werden.

Für die Erfindung ist es hier wesentlich, dass zeitgleich zum ersten Refokussierungsimpuls 3 ein schichtselektives Gradientenmagnetfeld 4 geschaltet wird, welches orthogonal ist zum schichtselektiven Gradientenmagnetfeld 2 zum Zeitpunkt des Anregungsimpulses 1, um so eine Volumenreduzierung zu erzielen, da nun die Refokussierung nur in dem gemeinsamen Bereich beider orthogonaler Schichten erfolgt. In einer Folge von Refokussierungsimpulsen 3, um aufeinander folgenden Spin-Echos zu erzeugen kann jeweils folgend ein zum vorherigen gewählten Gradientenmagnetfeld orthogonales Gradientenmagnetfeld gewählt werden. Diese Auswahlfolge kann sich wiederholen. In dieser Ausführung ist das Gradientenmagnetfeld 4 für die Volumenreduzierung in der Phasenkodierrichtung gewählt und könnte bei der nächsten Rephasierung in Frequenzkodierrichtung gewählt werden usf.

Die Figur zeigt hier auch zwei Alternativen der Diffusionswichtung. Es kann in einer der Alternativen mindestens ein bipolares Gradientenmagnetfeld 5 nach dem Anregungsimpuls 1 und zeitlich vor dem Refokussierungsimpuls 3 erzeugt werden. Beide Polaritätsanteile sind bevorzugt zeitlich gleich lang und gleich intensiv, so dass Sie sich in der Wirkung hinsichtlich Dephasierung / Rephasierung aufheben und so während der Wirkungsdauer stattfindende Diffusions- oder andere Bewegunsgprozesse, z.B. Blutfluß eine effektive Restdephasierung erzeugen, die nachweisbar ist.

In der zweiten Alternative kann ein zeitlich beabstandetes Paar unipolarer gleichlanger und gleich intensiver Gradientenmagnetfelder 6 erzeugt werden, die zeitlich um den Refokussierungsimpuls angeordnet sind, und sich deshalb ebenso in der Wirkung kompensieren mit der Ausnahme von Restdephasierung aufgrund von Diffusion oder anderen Bewegungsprozessen.

Diese zur Diffusionswichtung geschalteten Gradientenmagnetfelder können in beliebiger Wirkrichtung auf einzelnen Gradientenachsen oder als Kombination mehrerer Gradientenrichtungen erzeugt werden, hier in der ersten Alternative in Richtung der Phasenkodierung und in der zweiten Alternative in Richtung der Frequenzkodierung.

Mittels eines vor der Messung zeitweise geschalteten Phasenkodier-Gradientenmagnetfeldes 9 wird die Phasenkodierung für die nachfolgende Messung definiert und mit dem gleichzeitig zur Messung geschalteten Frequenzkodier-Gradientenmagnetfeld 7 eine räumliche Frequenzkodierung erzeugt, so dass sich in dieser Richtung die Präzessionsfrequenzen unterscheiden.

Durch die Streifendarstellung des Phasenkodier-Gradientenmagnetfeldes 9 wird dargestellt, dass die Phasenkodierung mehrfach hintereinander mit mehreren verschiedenen Intensitäten und somit Phasenkodierungen durchgeführt wird, um dann jeweils die Frequenzkodierung anzuwenden. Während der Frequenzkodierung mit den Frettuenzkodier-Gradientenmagnetfeld 7 kann das Spinecho 8 aus der selektierten Schicht mit der selektierten Phase erfasst werden.

Die in vertikaler Richtung dargestellte Hell-Dunkelfolge soll darstellen, dass nicht jede ansonsten notwendige Phasenkodierung ausgeführt wird, sondern hier nur symbolisch jede zweite bzw. allgemein jede n₋te (n = ganze Zahl oder rationale Zahl), so dass eine sogenannte Unterabtastung und/oder partielle Abtastung des Datenraumes erfolgt, mit einem daraus resultierenden n-fachen Geschwindigkeitsvorteil. Rechnerisch kann dies kompensiert werden unter Zugrundelegung von Symmetrien und Korrelationen, die für den Datenraum bekannt sind. Die Auswertung der Daten erfolgt dann erfindungsgemäß durch eine Komplettierung der unterabgetasteten und/oder unvollständig abgetasteten Daten über Ausnutzung zeitlich-räumlicher Korrelationen innerhalb einer Zeitserie von Daten - bekannt als k-t BLAST Ansatz - und/oder mittels Vervollständigung der fehlenden Daten durch die Bildung komplex konjugierter Daten aus den ursprünglichen, komplexen Daten -bekannt als Half-Fourier-Ansatz..

Ersichtlich kann die Gesamtsequenz zur Vorbereitung und Messung innerhalb nur eines RR-Intervalls des Herzschlages ausgeführt werden. Ersichtlich ist die Gesamtsequenz zur vorbereitenden Blutunterdrückung und Messung unabhängig von den T1-Relaxatianseigenschaften des Blutes und hat gegenüber dem Stand der Technik den Vorteil, dass Sie ohne weitere Modifikationen sowohl unter nativen Bedingungen als in Anwesenheit von Kontrastmitteln eingesetzt werden kann. Ersichtlich ist kann die Gesamtsequenz zur Vorbereitung und Messung durch Einfügen einer weiteren Verzögerungszeit Tau2, die identisch mit der Verzögerungszeit Tau ist und wie diese variiert wird und zwischen dem ersten und zweiten Refokussierungsimpuls integriert ist von einer T2* gewichteten Kartierungstechnik ohne weitere zusätzliche Änderungen in eine T2-Kartierungstechnik überführt werden.

Die Kombination dieser hier beschriebenen Techniken erzeugt einen Geschwindigkeitsvorteil gegenüber dem Stand der Technik, der eine Größenordnung überschreiten kann.

## Patentansprüche

1. Verfahren zum Betrieb eines Magnetresonanztomographen zur ortsaufgelösten Spinresonanzmessung an einem Objekt, welches in einem statischen Magnetfeld B0 angeordnet wird, wodurch sich eine Ausrichtung der Spins des Objektes und eine longitudinale Nettomagnetisierung Mz entlang der Magnetfeldrichtung Z ergibt, wobei mittels wenigstens eines Hochfrequenz-Anregungs-Impulses in Resonanz ein Spin-Flip um einen gewünschten Flip-Winkel erzeugt wird, bei dem eine transversale Magnetisierungskomponente Mxy erzeugt oder geändert wird, deren T2*-Reiaxation zur Durchführung suszeptibilitätsgewichteter Messungen erfasst wird wofür eine messtechnische Erfassung von mehreren Spin-Echo-Signalen aus einem gewünschten Volumenelement des Objektes erfolgt, die nach einem HF-Anregungsimpuls durch eine Sequenz von untereinander äquidistanten Hochfrequenz-Refokussierungsimpulsen erzeugt werden, wobei den Echo-Signalen vor deren Erfassung eine Suszeptibilitätsabhängigkeit aufgeprägt wird durch eine zwischen dem Hochfrequenz-Anregungsimpuls und dem ersten Hochfrequenz-Refokussierungssimpuls zusätzlich eingefügte Evolutionszeit zur Entwicklung der durch Inhomogenitäten des Magnetfeldes erzeugten Dephasierung der durch den HF-Anregungsimpuls erzeugten transversalen Magnetisierung Mxy und wobei der Ort des messtechnisch erfassten Volumenelements des Objektes durch mehrere zumindest zeitweise dem homogenen Magnetfeld B0 überlagerte Gradientenmagnetfelder bestimmt wird und der Start und/oder Vorbereitungssequenzen einer Messung an eine oder mehrere erfasste Formen physiologischer Bewegung synchronisiert wird/werden, **dadurch gekennzeichnet, dass** innerhalb der Zeit eines R-R-Intervalls des Herzens
a. eine Vorbereitungssequenz zur Unterdrückung von Signalbeiträgen aus dem Blut ausgeführt wird, insbesondere durch eine Sättigungssequenz
b. und wobei zumindest der erste Refokussierungsimpuls (3) zeitgleich mit einem schichtselektiven Gradientenmagnetfeld (4) erzeugt wird, welches orthogonal wirkt zur dem schichtselektiven Gradientenmagnetfeld (2) zur Zeit der Erzeugung des HF-Anregungsimpulses (1)
c. und wobei die Messwerterfassung und Bilderzeugung mittels einer Unterabtastung des Datenraumes und/oder einer partiellen Abtastung des Datenraumes erfolgt.

2. Verfahren nach Anspruch 1, **dadurch gekennzeichnet, dass** die schichtselektiven Gradientenmagnetfelder (4), die zeitgleich zu den Refokussierungsimpulsen (3) erzeugt werden bei wenigstens zwei aufeinanderfolgenden Refokussierungssimpulsen (3) orthogonal zueinander angeordnet sind.

3. Verfahren nach einem der vorherigen Ansprüche, **dadurch** gekenntzeichnet dass eine Diffusionswichtung vorgenommen wird durch Erzeugung mindestens eines bipolaren Gradientenmagnetfeldes (5) vor einem Refokussierungssimpuls oder zwischen den Refokussierungspulsen (3) oder zweier unipolarer Gradientenmagnetfelder (6) um einen Refokussierungssimpuls (3) herum.

4. Verfahren nach Anspruch 3, **dadurch gekennzeichnet dass** die Erzeugung des bipolaren Gradientenmagnetfeldes (5) innerhalb der sich nach dem HF-Anregungsimpuls (1) anschließenden Evolutionszeit erfolgt.

5. Verfahren nach einem der vorherigen Ansprüche, **dadurch gekennzeichnet, dass** die bildgebende Auswertung des Datenraumes durch eine Half-Fourier-Rekonstruktion erfolgt.
